# EUROPEAN PATENT APPLICATION

(11) **EP 4 411 831 A1**
(43) Date of publication of application: **07.08.2024**
(21) Application number: 23305143.2
(22) Date of filing: 03.02.2023
(51) Int. Cl.: H01L 31/0224, G01J 3/10, G01N 21/3586, H01L 31/0232, H01L 31/08, H01L 31/09, H01L 33/00

(54) **PHOTOCONDUCTIVE ANTENNA FOR TERAHERTZ WAVES, METHOD FOR PRODUCING SUCH PHOTOCONDUCTIVE ANTENNA AND TERAHERTZ TIME DOMAIN SPECTROSCOPY SYSTEM**

(71) Applicant: Centre national de la recherche scientifique, 75016 Paris (FR); Ecole Normale Supérieure de Paris, 75320 Paris Cedex 05 (FR); SORBONNE UNIVERSITE, 75006 Paris (FR); Université Paris Cité, 75006 Paris (FR)
(72) Inventor: PALOMO, José, 95100 ARGENTEUIL (FR); MICICA, Martin, 75005 PARIS (FR); DHILLON, Sukhdeep, 92340 Bourg La Reine (FR)
(74) Representative: IPAZ

(57) **Abstract**

A digitated photoconductive antenna (10) to generate and/or detect terahertz radiation, the photoconductive antenna comprising a substrate (SB) made of a compound semiconductor, and comprising a plurality of digitated electrodes (DE) and two contact pads (CP) on the front face of the substrate (SB), characterized in that :
- it comprises a metallization layer (ML) being made on said front surface of the substrate (SB) for said digitated electrodes (DE) and said contact pads (CP),
- said digitated electrodes (DE) are equally spaced by a distance Δ, each digitated electrode being linked to another digitated electrode by a portion of said metallization layer called integrated resistance (IR) and presenting an intrinsic electrical resistance
- each contact pad is linked to a respective digitated electrode by a part (MP) of said metallization layer such that said contact pads are adapted to apply a voltage across said digitated electrodes.

## Description

### Technical field:

The present invention relates generally to a photoconductive antenna, a method for producing a photoconductive antenna and a terahertz time domain spectroscopy system.

### Prior Art:

The terahertz (THz) frequency range, which lies between the microwave and mid-infrared ranges, offers unique opportunities in a variety of application domains which include medical and security imaging, non-destructive testing, submillimeter-astronomy and the detection of gases.

Over the last decade, technological solutions have emerged that are extremely promising to cover the lack of devices in this part of the electromagnetic spectrum. One of the most important and widespread technique is THz time domain spectroscopy (THz-TDS). It is based around optical ultrafast lasers for the generation and detection of THz pulses. The generation of THz pulses is usually performed through ultrafast excitation of photoconductive antennas.

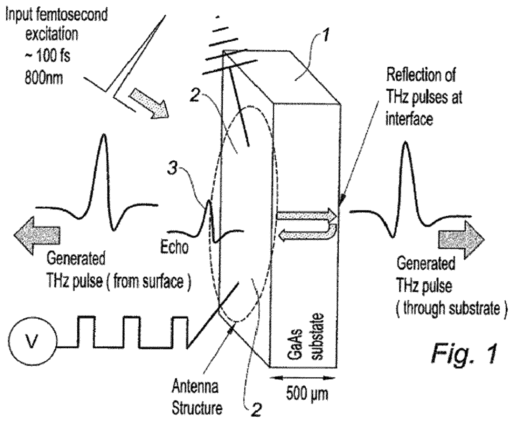

Referring to figure 1, a photoconductive antenna has usually a particular substrate (1), usually a semiconductor, with two electrodes (2) on the substrate (1). The mechanism is as follows: irradiating the gap between the electrodes (2) with ultrashort pulse laser light while applying a voltage across the electrodes (2) causes excited photocarriers to generate a time-varying electrical current between the electrodes (2). The time profile of this current is both related to the optical excitation pulse length and the carrier recombination time in the substrate. This current induces the emission of a terahertz wave with a broad frequency spectrum via the photoconductive antenna. It should be noted that THz-TDS systems can use another photoconductive antenna or an electro-optic crystal as a detector for terahertz waves.

In a typical semiconductor antenna, the particular semiconductor can be selected from compound semiconductors such as GaAs, InGaAs, AlGaAs, GaAsP, and InGaAsP. Further, low-temperature-grown GaAs (LT-GaAs) films, grown in the crystalline form are very commonly used (IEEE J Quant. Elect. 28 2464 (1992)) for short carrier lifetime and large resistance. LT-GaAs is grown as a crystal on a semi-insulating GaAs (SI-GaAs) substrate in most cases. This causes various problems while THz waves pass through the SI-GaAs substrate, such as reduced efficiency of use of the power of the THz waves and spectral narrowing.

THz-TDS characteristics, including the dynamic range, bandwidth, signal-to-noise ratio and frequency resolution are closely related to the pulse specifications; consequently its performances are mainly linked to the characteristics of the pulse emitter.

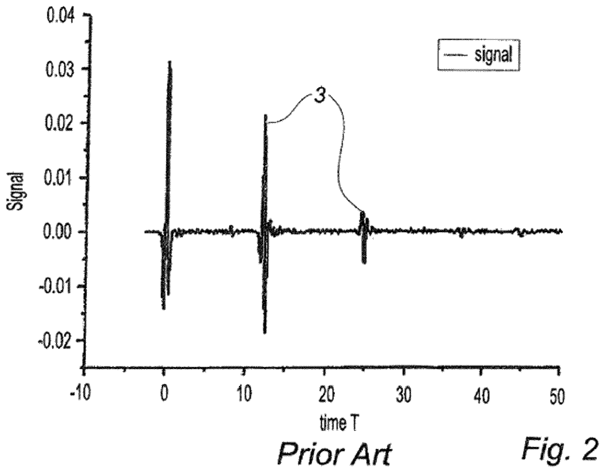

More specifically, a THz-TDS has a frequency resolution limited by the total scanning time, which is mainly limited by unwanted interfering echoes (3) of the emitted THz pulse - see figure 2. Indeed, the problem of having echoes arises when the original signal is reflected from discontinuities, such as change in refractive index, on the beam path.

If most of the echoes are manageable (for instance by means of samples, windows electro-optic detection crystals with thicker or wedged dimensions), in the case of photoconductive antenna, an echo arises from the reflection of the original pulse in its own substrate. Because of the short distances of a standard size wafer, it is this echo that limits in practice the spectral resolution of the system. With a photoconductive antenna made out of a 500 µm GaAs wafer (n = 3.64 refractive index in the THz range), a THz echo arises after only 12 ps, limiting the resolution to a lower bound of typically 90 GHz (3 cm⁻¹).

Although such a resolution is low enough for many applications, several applications require better performances. For example, spectroscopic methods for the sensing and identification of gases have shown great promise, owing to their inherent non-invasive nature, but also because they are highly selective. Compared to mid-IR spectrum, which consists of complex signature of vibrational and rovibrational transitions, the THz fingerprint of many polar molecules consist of simple rotational spectra with unique spectral signature, which may provide more efficient and accurate detection of many gases. To resolve such spectrums, higher resolution is needed, since most of pure rotational spectrum spacing typically ranges from 0.1 cm⁻¹ to 10 cm⁻¹ (e.g. rotational constant B = 2 cm⁻¹ for CO molecule).

For higher spectral resolution in THz-TDS systems, several methods have been proposed to deal with echoes issue. THz anti-reflection coatings have been developed but have several drawbacks: the dielectric ones are wavelength dependent (IEEE Microwave and guided wave letters, Col. 10, N° 7, july 2000 "An anti-Reflection coating for silicon optics at terahertz frequencies" A.J. Gatesman, J. Waldman, M. Ji, C. Musante, and S. Yngvesson), while broadband design might be achieved with thin metal coating (Physical Review B 77, 195405; 2008; "Nanostructured gold films as broadband terahertz antireflection coatings"; Andreas Thoman, Andreas Kern, Hanspeter Helm, and Markus Walther)^{]} but are difficult to realize and introduce important losses.

Alternative approaches apply numerical methods, either by deconvolution with reference signal, or echo cancelation with a deconvolution algorithm.

The international patent application WO 2016/097975 A1 describes a photoconductive antenna that generates and/or detects terahertz waves and suppresses echoes that usually originate from antenna's substrate reflection, without any numerical post-processing, and which is not affected by losses. The antenna comprises a substrate (1) and at least two electrodes (2) onto the front face of the substrate (1). The photoconductive antenna further comprises a layer (4) obtained in a material reflective to terahertz waves, said layer extending below the front face of the substrate (1) at a distance *d* = *λ*/2 where *λ*, corresponds to the maximum frequency that needs to be emitted/detected.

As there is no possibility of the THz pulse to propagate beyond the inserted metal plane this eliminates the echo that results from the interface between the substrate and air. Further, as there are no echoes from this system, all the THz power is in the original THz pulse resulting in a higher extraction of power generated.

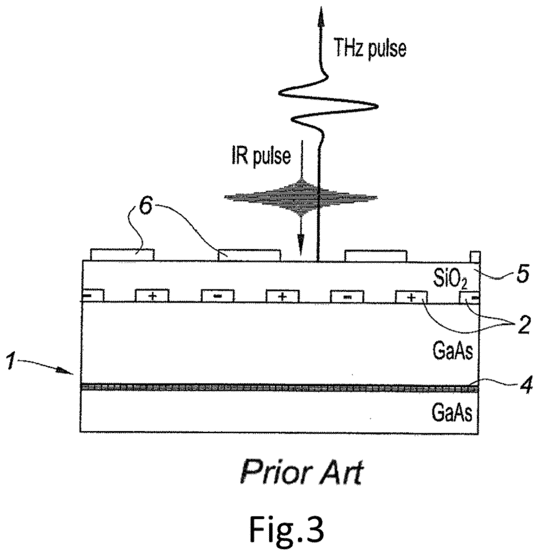

Although the antenna of figure 3 is satisfactory, the method for producing such an antenna is complex.

More specifically, the manufacturing method comprises a first step to form a first metallization layer for the interdigitated electrodes (2). Then a second step is needed to form a layer (5) of SiO₂ over the first metallization layer. The method comprises a third step to form a second metallic layer composed of metallic fingers (6) covering gaps with a periodicity double that of the first metallization layer. This permits optical excitation of every second period of the gaps of the first metallization and hence excitation of only one bias field direction, avoiding destructive interferences of the generated THz far field. The structure of the antenna of figure 3 is based on an electrode geometry called "interdigitated geometry" known to be an efficient way to generate THz pulses. In addition, it delivers a strong emitted field with good directivity since a large area of the electrodes can be illuminated (~ 500 µm diameter), and a low bias is needed owing to the possibility of a small electrode spacing. The term "interdigitated" refers to the spatial arrangement of the electrodes (2) with respect to the metallic fingers.

This third step cannot be done directly after the second step in the same environment because it requires sub-steps of deposition and patterning. Thus, it requires precise realignment to properly dispose the metallic fingers (6) with respect to the electrodes (2). This results in a complex manufacturing process, a reduced fabrication yield and a higher cost.

To overcome the above-mentioned limitations, a need exists for a novel antenna design and an associated manufacturing process that increase fabrication yield.

### Summary of the invention:

To this end, an object of the invention is a digitated photoconductive antenna to generate and/or detect terahertz radiation, the photoconductive antenna comprising a substrate made of a compound semiconductor, and comprising a plurality of digitated electrodes and two contact pads on the front face of the substrate characterized in that it comprises a metallization layer being made on said front surface of the substrate for said digitated electrodes and said contact pads, wherein said digitated electrodes are equally spaced by a distance Δ, each digitated electrode being linked to another digitated electrode by a portion of said metallization layer called integrated resistance and presenting an intrinsic electrical resistance, and wherein each contact pad is linked to a respective digitated electrode by a part of said metallization layer such that said contact pads are adapted to apply a voltage across said digitated electrodes.

According to an embodiment, the metallization layer is made of a material presenting an electrical resistivity greater that 100 µΩ. cm, preferably higher than 200 µΩ. cm. Preferably, the metallization layer is made of *β*-tantalum.

According to an embodiment, each integrated resistance presents an intrinsic resistance comprised between 0.1 and 10 *k*Ω. Preferably, the metallization layer has a thickness comprised between 100 nm and 300 nm.

According to an embodiment, the distance Δ is lower than 2 *µm*. Preferably, the distance Δ is lower than 0.2 *µm*.

According to an embodiment, the digitated photoconductive antenna comprises at least one layer, called reflective layer made of a material reflective to terahertz radiation, said reflective layer extending below the front face of the substrate at a distance d=λ/2 where λ corresponds to the maximum frequency that needs to be emitted/detected. Preferably, the reflective layer is a metal layer.

According to an embodiment, the substrate is a semiconductor substrate chosen among the following list of GaAs, InGaAs, AlGaAs, GaAsP, Si, quartz, InGaAsP, LT-GaAs, ErAs:GaAs, Fe:InGaAs or InGaAsN and materials II-VI.

Another object of the invention is a method for producing a digitated photoconductive antenna according to the invention, the method comprising at least the following steps of :
- Forming a metallization layer on a front surface of a substrate) made of a compound semiconductor
- Patterning said metallization layer to form a plurality of digitated electrodes and two contact pads on the front face of the substrate and such that:
   ∘ said digitated electrodes are equally spaced by a distance Δeach digitated electrode being linked to another digitated electrode by a portion of said metallization layer called integrated resistance and presenting an intrinsic electrical resistance
   ∘ each contact pad is linked to a respective digitated electrode by a part of said metallization layer such that said contact pads are adapted to apply a voltage across said digitated electrodes.

According to the invention, the method does not comprise a further step consisting in forming an additional metallization layer above said metallization layer.

According to an embodiment, the digitated electrodes and the contact pads are formed by photolithography and/or electron-beam lithography or a lift-off technique.

Another object of the invention is a terahertz time domain spectroscopy system comprising a generator section that generates a terahertz radiation and a detector section that detects the terahertz wave, at least one of the generator section and the detector section comprising the digitated photoconductive antenna according to the invention.

### Brief description of the drawings:

Other features, details and advantages of the invention will become apparent from the description made with reference to the annexed drawings, which are given as examples and which represent, respectively:
Fig.1 a schematic view of a prior art photoconductive antenna,
Fig.2 a time domain terahertz pulse generated by a prior art photoconductive antenna,
Fig.3 a schematic view of a prior art photoconductive antenna,
Fig.4A and Fig.4B schematic views of a photoconductive antenna according to the present invention,
Fig.5A a time domain terahertz pulse generated by a photoconductive antenna according to the invention,
Fig.5B the spectral response of the terahertz pulse generated by a photoconductive antenna according to the invention,
Fig.6 a schematic sectional view of one embodiment of a photoconductive antenna according to the invention,
Fig.7 a flowchart of a method for producing aphotoconductive antenna according to the invention,
Fig.8A to 8F are schematic views of the different steps of the method for producing a photoconductive antenna according to the invention,
Fig.9 is a schematic representation of a terahertz time domain spectroscopy system comprising at least one photoconductive antenna according to the invention,

In the drawings, unless otherwise indicated, the elements are not to scale.

### Detailed specification:

Figures 3A and 3B are schematic illustrations of a front view and a side view respectively of the digitated photoconductive antenna 10 adapted to generate and/or detect terahertz waves according to the present invention.

The photoconductive antenna 10 comprises a substrate SB made of a compound semiconductor which can be selected from compound semiconductors such as of GaAs, InGaAs, AlGaAs, GaAsP, Si, quartz, InGaAsP, LT-GaAs, ErAs:GaAs, Fe:InGaAs or InGaAsN and materials II-VI.

The antenna 10 further comprises a plurality of digitated electrodes DE and two contact pads CP on the front face of the substrate SB. The digitated electrodes DE and the contact pads CP are patterned from a same metallization layer ML.

The digitated electrodes DE are equally spaced by a distance Δ and each digitated electrode are linked to another digitated electrode by a portion of the metallization layer ML called integrated resistance IR.

Further, each contact pad CP is linked to a respective digitated electrode DE by a part (referenced MP) of the metallization layer ML. Thus, the contact pads CP are adapted to apply a voltage across the digitated electrodes DE. Given the geometry of the antenna 10 the digitated electrodes present an identical polarity when such a voltage is applied.

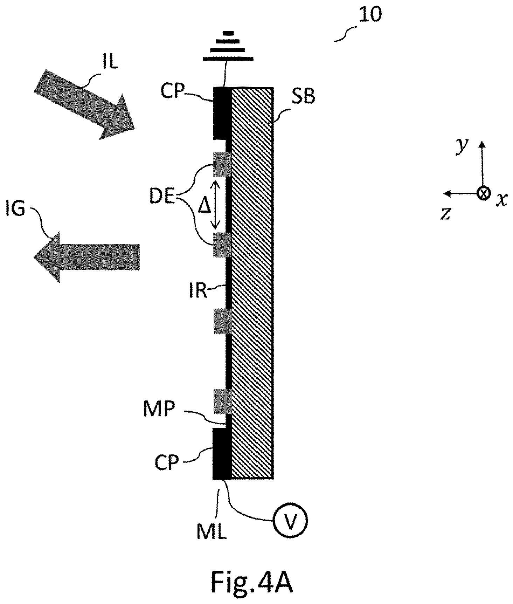

The antenna 10 can be operated as shown in figure 4A. An ultrafast laser source (eg: a Ti:Sapphire femtosecond laser) generates laser pulses IL. Given as an example, the pulses IL have a duration of typically 100 fs and a repetition rate of 77 MHz. The pulses IL are then focused onto the photoconductive antenna 10 with an irradiance of approximately 500 W/cm². A voltage bias is applied across the electrodes DE via the contact pads CP while the pulses IL illuminate the antenna.

Each integrated resistance IR separating each pair of digitated electrodes DE induces an electrical potential difference between the electrodes which in turns produces an electrical field between the electrodes. This causes excited photocarriers -generated by the photons of the pulses IL absorbed by the substrate- to generate a time-varying electrical current between the electrodes DE. This induces a radiated electrical field proportional to its temporal derivative: the THz pulses IG. Time profile of this current is both related to the optical excitation pulse length and the carrier recombination time in the substrate. As each pair of electrode presents the same polarity, there is no destructive interferences of the generated THz far field. This is a stark difference compared to the antenna according to figure 3 where the metallic fingers (6) covering gaps between the electrodes with a periodicity double that of the first metallization layer are required to permit optical excitation of every second period of the gaps of the first metallization and hence excitation of only one bias field direction, thus avoiding destructive interferences of the generated THz far field

Typically, the voltage applied generates an electrical field of around 10 kV/cm between the electrodes. This intensity is suitable to provide a strong enough acceleration of the photo-excited carriers in the substrate SB to induce the generation of THz pulses IG.

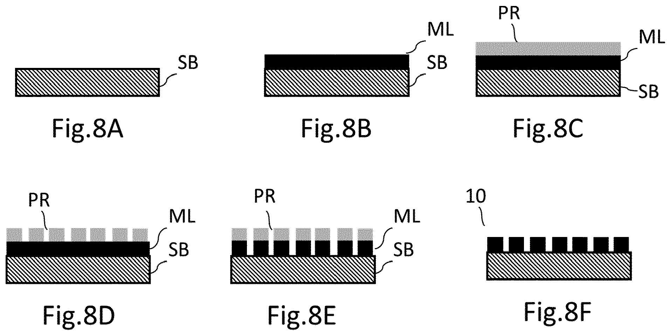

As it will be explained further below referring to figures 8A to 8F, the antenna 10 according to the invention has a structure that can be manufactured via a process much simpler and thus more cost-effective that the antenna with a interdigitated geometry of the prior art (e.g. the antenna of figure 3).

In a specific embodiment (referenced SE), the laser pulses IL have a wavelength of 800 nm and the antenna comprises 20 digitated electrodes DE patterned from a layer ML of *β*-tantalum deposited over a 500 *µm* thick GaAs substrate SB. Each electrode DE has a width *w* = 8 *µm* and is separated by a distance Δ = 1,5 µm from an adjacent electrode. Thus, the total width *wₜ* of the digitated electrodes DE is approximately 200 *µm*. A voltage bias of 28,5 V applied between the contact pads CP induces an electrical bias field of 10 kV/cm between the electrodes.

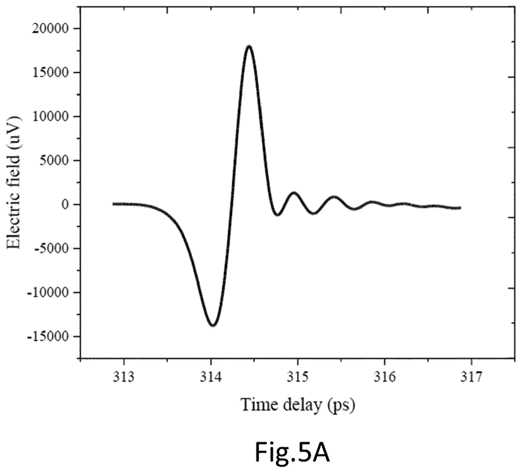

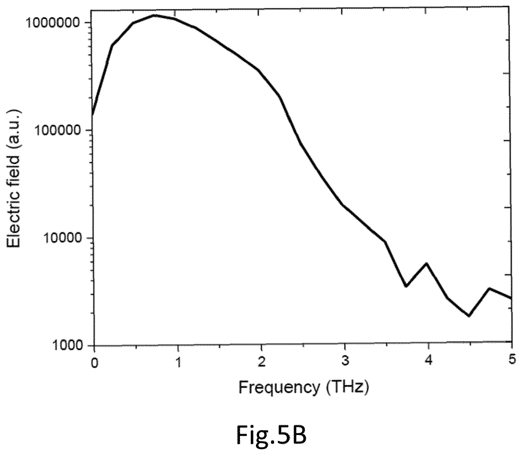

Figures 5A and 5B show respectively the temporal profile and the spectrum of a THz pulse IG generated by the antenna 10 according to the specific embodiment SE. More precisely, figure 5A is a typical time scan of the emitted THz field that can be obtained for the antenna 10 and figure 5B is the spectrum obtained from the same time scan (Fourier transform of time scan) in the spectral range of 0 THz to 5 THz. As can be seen from figure 5B, the emitted THz spectrum extends up to 5 THz. These figures prove the feasibility of the invention.

Preferably, the metallization layer ML is made of a material presenting an electrical resistivity greater that 100 µΩ. cm, preferably higher than 200 µΩ. cm. This helps decrease the area of each integrated resistance IR to achieve a given intrinsic resistance and thus increase the number of digitated electrodes DE in this design according to figures 3A and 3B for an antenna 10 of predetermined area. This lead to an increase of the generation efficiency of the THz pulses IG.

According to a preferred embodiment, the metallization layer ML is made of *β-*tantalum. This metal is advantageous because it is easily deposited (sputtering) at a thin film resistivity of between 170 and 230 µOhm.cm. This gives an IR resistance value of around a few *k*Ω for an ML thickness of around 200nm. It is also stable and durable over time.

To further increase of the generation efficiency of the THz pulses IG, it is preferable that the metallization layer has a thickness comprised between 50 nm and 1 µm and even preferably between 100 and 300 nm. It is not advisable to have a metallization layer with a thickness lower than 50 nm because the integrated resistances IR might melt when applying a voltage bias between the contact pads CP. As explained above, the value of the integrated resistances IR also depends on the resistivity of the deposited material ML. Further, it is not advisable to have a metallization layer with a thickness greater than 500 nm because the greater the thickness, the lower the IR resistance and therefore the higher the current for the same voltage, which has the disadvantage of having a more powerful power supply and also a risk of overheating the IR resistance.

To further increase the number of digitated electrodes DE for an antenna 10 of predetermined area, one can reduce the distance Δ between the adjacent electrodes DE. The width w of the electrodes DE can also be reduced. To this effect, the distance Δ is preferably, lower than 2 *µm*. The advantage of a relatively smaller Δ is to provide a large electric field at a low electric voltage.

In a preferred embodiment, the distance Δ is lower than 0.2 *µm*. Indeed, with such a small distance Δ between the adjacent electrodes DE, the surface plasmons excited by the laser pulses IL of two adjacent electrodes DE start coupling. This coupling enhances the electric field in the gap between the electrodes. This coupling also increases the absorption of the laser pulses IL near the electrodes. This leads to an increase of the generation efficiency of the THz pulses IG.

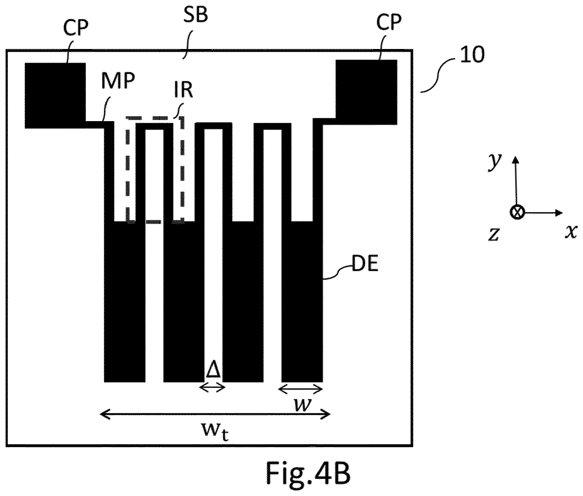

The invention allows the exploration of new research topics such as the plasmonic effect because it is easier or simpler to make a sample. Indeed, to observe this effect, it is necessary to have a width W of the electrodes and a gap Delta of a hundred nanometers. The old method having more manufacturing steps including an alignment on the electrodes it becomes very complicated to manufacture. The plasmonic enhancement of the absorption and the electric field is obviously dependent of the geometry and the dimensions of the electrodes. In a more basic approach, given the geometry illustrated in the figure 4B, the plasmonic enhancement can be optimized with the parameters w and Δ. In the specific embodiment SE, a first order optimization of the plasmonic enhancement is achieved when w = Δ = 100 nm. In a more general approach, with any given geometry, the plasmonic enhancement (and thus the THz generation efficiency) can be optimized with FDTD simulation tools.

According to a preferred embodiment, each integrated resistance IR presents an intrinsic electrical resistance preferably comprised between 0.1 and 10 *k*Ω. Preferably, each integrated resistance IR has an intrinsic electrical resistance comprised between 0.5 and 1.5 *k*Ω. Given the dimensions of the specific embodiment SE, this value of resistance is particularly suited to induce an electrical bias field of 10 kV/cm between the electrodes DE with a moderate voltage bias (e.g. 28,5V for the contact pads or 1,5 V for each gap between the electrodes).

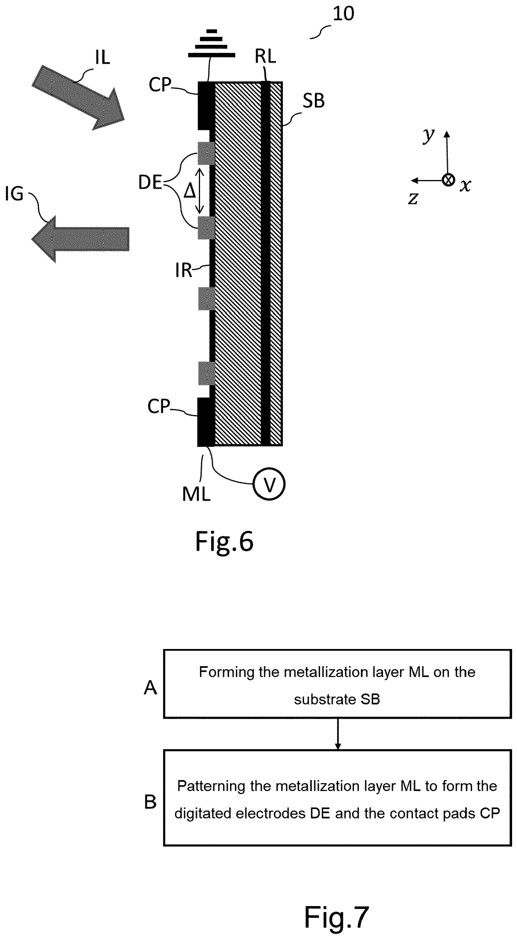

Figure 6 is a schematic illustration of a side view a photoconductive antenna 10 according to an embodiment of the invention. In this embodiment, the antenna 10 further comprises a layer -called reflective layer RL- made of a material reflective to terahertz radiation. The reflective layer RL extends below the front face of the substrate SB at a distance d=λ/2, where λ corresponds to the maximum frequency that needs to be emitted/detected. As the international patent application WO 2016/097975 A1 thoroughly describes, the reflective layer RL eliminates the echo that results from the interface between the substrate and air. As there are no echoes in this configuration, all the THz power is in the original THz pulse IG resulting in a higher extraction of power generated and a higher THz generation efficiency.

Preferably, the reflective layer RL is a metal layer such as a metal chosen among the following list of gold and/or titanium and/or silver and/or copper.

Figure 7 is a flowchart of the method according to the invention to produce the digitated photoconductive antenna 10 according to the invention. The method of the invention comprises a first step A which consists in forming the metallization layer ML on a front surface of the substrate SB. This step can be done using any appropriate method well known by the man skilled in the art without departing from the scope of the invention (e.g. sputtering). One can also have several steps to have the integrated resistances IR made out of a different material that the electrodes DE.

Then in a second step B, we pattern the metallization layer ML to form the digitated electrodes DE and the two contact pads CP on the front face of the substrate SB. Once again, this step can be done using any appropriate method well known by the man skilled in the art without departing from the scope of the invention such as photolithography and/or electron-beam lithography or any lift-off technique.

As is understood by one skilled in the art, this process can be done with lift off technique. In this case a first lithography step on the resist is necessary to achieve with the desired antenna design, then deposit the metal and make a lift-off step to remove the resist.

Figures 8A to 8F shows the different steps of the method for producing the digitated photoconductive antenna 10 according to a particular embodiment of the invention in which the second step B of the method uses a photolithography technique. Figures 8A to 8B illustrate the first step A of forming the metallization layer ML on the substrate SB using a metal evaporation or sputtering technique for example. In figure 8C, the photoresist layer PR is deposited onto the metallization layer ML for example via spincoating. Then, the photoresist layer PR is patterned typically by light exposition and then the use of a developer solution (figure 8D). This substep can be done appropriate method well known by the man skilled in the art without departing from the scope of the invention such as using a laserwriter, optical photonmask, etc ... Then, the parts of the metallization layer ML not covered by the residual photoresist layer PR are removed by any appropriate method, such as mechanical and/or chemical etching method (figure 8E). Finally, the residual photoresist layer PR is removed, typically using a liquid solution called "resist stripper", solvent or by plasma and we obtain the antenna 10 according to the invention (figure 8F).

As can be seen from figure 7 and figures 8A to 8F, the method according to the invention requires a single step of metallic deposition to obtain the electrodes DE and the contact pads CP both and IR. Therefore, it is faster and less complex than the method for producing the antenna according to figure 3 which requires two separate steps of metallic deposition with a precise realignment between those two steps. This implies that the antenna 10 according to the invention will be less expensive than the antenna according to figure 3.

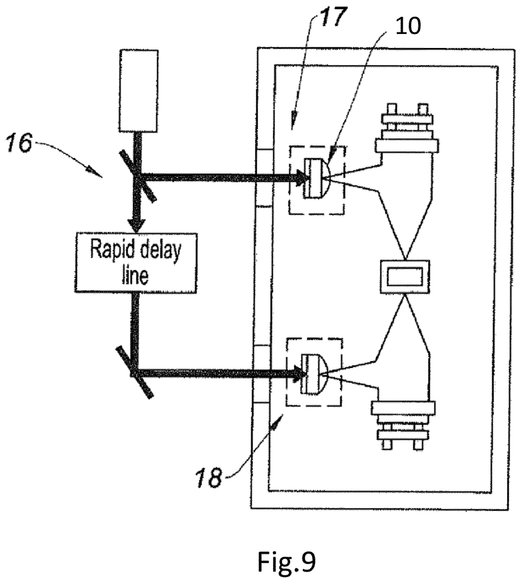

Referring to figure 9, the photoconductive antenna 10 according to the invention is intended to be used in a terahertz time domain spectroscopy system 16 comprising at least a generator section 17 that generates a terahertz wave and a detector section 18 that detects the terahertz wave, at least one of the generator section 17 and the detector section 18 having the photoconductive antenna 10 according to the invention. In this embodiment, the generator section 17 has the photoconductive antenna according to the invention.

It should be noted that the photoconductive antenna according to the invention can also be used for continuous wave THz systems, such as continuous wave THz spectrometer, without departing from the scope of the invention.

Although embodiments of the present disclosure have been described in details, those skilled in the art should understand that they may make various changes, substitutions and alterations herein without departing from the spirit and scope of the present disclosure. Accordingly, all such changes, substitutions and alterations are intended to be included within the scope of the present disclosure as defined in the following claims.

For example, photoconductive antennas according to the invention may have a layer of SiO2 or another dielectric directly above the electrodes DE.

In the claims, means-plus-function clauses are intended to cover the structures described herein as performing the recited function and not only structural equivalents, but also equivalent structures

The invention is essentially based on integrated IR resistors which has several consequences such as the simplification of the process and perspectives such as the demonstration of the plasmonic effect.

## Claims

1. A digitated photoconductive antenna (10) to generate and/or detect terahertz radiation (IG), the photoconductive antenna comprising a substrate (SB) made of a compound semiconductor, and comprising a plurality of digitated electrodes (DE) and two contact pads (CP) on the front face of the substrate (SB), **characterized in that**:
- it comprises a metallization layer (ML) being made on said front surface of the substrate (SB) for said digitated electrodes (DE) and said contact pads (CP),
- said digitated electrodes (DE) are equally spaced by a distance Δ, each digitated electrode being linked to another digitated electrode by a portion of said metallization layer called integrated resistance (IR) and presenting an intrinsic electrical resistance
- each contact pad is linked to a respective digitated electrode by a part (MP) of said metallization layer such that said contact pads are adapted to apply a voltage across said digitated electrodes.

2. The digitated photoconductive antenna according to claim 1, **characterized in that** said metallization layer is made of a material presenting an electrical resistivity greater that 100 µΩ. cm, preferably higher than 200 µΩ. cm

3. The digitated photoconductive antenna according to claim 2, **characterized in that** said metallization layer is made of *β*-tantalum.

4. The digitated photoconductive antenna according to any of the preceding claims, **characterized in that** each integrated resistance (IR) presents an intrinsic resistance comprised between 0.1 and 10 *k*Ω.

5. The digitated photoconductive antenna according to claim 4, **characterized in that** said metallization layer has a thickness comprised between 100 nm and 300 nm.

6. The digitated photoconductive antenna according to claim 4, **characterized in that** said distance Δ is lower than 2 *µm*.

7. The digitated photoconductive antenna according to claim 4, **characterized in that** said distance Δ is lower than 0.2 *µm*.

8. The digitated photoconductive antenna according to any of the preceding claims, **characterized in that** it comprises at least one layer, called reflective layer (RL), made of a material reflective to terahertz radiation, said reflective layer (RL) extending below the front face of the substrate (SB) at a distance d=λ/2 where λ corresponds to the maximum frequency that needs to be emitted/detected.

9. The digitated photoconductive antenna according to claim 6, **characterized in that** the reflective layer (RL) is a metal layer.

10. The digitated photoconductive antenna according to any of the preceding claims, **characterized in that** the substrate (SB) is a semiconductor substrate chosen among the following list of GaAs, InGaAs, AlGaAs, GaAsP, Si, quartz, InGaAsP, LT-GaAs, ErAs:GaAs, Fe:InGaAs or InGaAsN and materials II-VI.

11. A method for producing a digitated photoconductive antenna (10) according to any of the preceding claims, the method comprising at least the following steps of :
A. Forming a metallization layer (ML) on a front surface of a substrate (SB) made of a compound semiconductor
B. Patterning said metallization layer (ML) to form a plurality of digitated electrodes (DE) and two contact pads (CP) on the front face of the substrate (SB) and such that:
∘ said digitated electrodes (DE) are equally spaced by a distance Δeach digitated electrode being linked to another digitated electrode by a portion of said metallization layer (ML) called integrated resistance (IR) and presenting an intrinsic electrical resistance
∘ each contact pad is linked to a respective digitated electrode by a part of said metallization layer such that said contact pads are adapted to apply a voltage across said digitated electrodes.

12. The method for producing a photoconductive antenna according to claim 11, **characterized in that** it does not comprise a further step consisting in forming an additional metallization layer above said metallization layer (ML).

13. The method for producing a photoconductive antenna according to claim 11 or 12, **characterized in that** the digitated electrodes (DE) and the contact pads are formed by photolithography and/or electron-beam lithography or a lift-off technique.

14. A terahertz time domain spectroscopy system (16) comprising a generator section (17) that generates a terahertz radiation and a detector section (18) that detects the terahertz wave, at least one of the generator section (17) and the detector section (18) comprising the digitated photoconductive antenna (10) according to claim 1.
